# EUROPEAN PATENT APPLICATION

(11) **EP 1 793 428 A1**
(43) Date of publication of application: **06.06.2007**
(21) Application number: 06024558.6
(22) Date of filing: 27.11.2006
(51) Int. Cl.: H01L 33/00, H01L 21/24

(54) **Semiconductor light emitting device having reflection layers comprising silver with improved ohmic contact**

(30) Priority: 01.12.2005 JP 2005348293
(71) Applicant: SONY CORPORATION, Tokyo (JP)
(72) Inventor: Watanabe, Yoshiaki Sony Corporation, Tokyo (JP); Hino, Tomonori Sony Corporation, Tokyo (JP); Kobayashi, Toshimasa Sony Corporation, Tokyo (JP); Narui, Hironobu Sony Corporation, Tokyo (JP)
(74) Representative: Müller - Hoffmann & Partner

(57) **Abstract**

A semiconductor light emitting device having high reflectivity and a high electrical contact property between a light reflection layer and a semiconductor layer is provided. The semiconductor light emitting device is formed by laminating a semiconductor layer (20), a base layer (30) and a light reflection layer (31) in this order. The semiconductor layer is formed by laminating a buffer layer (21), a GaN layer (22), an n-type contact layer (23), an n-type cladding layer (24), an active layer (25), a p-type cladding layer (26) and a p-type contact layer (27) in this order. The base layer (30) is formed on a surface of the p-type contact layer (27), and is made of a transition metal with Ag (silver) with a thickness of 1 nm to 10 nm inclusive. The light reflection layer (31) is formed on a surface of the base layer (30), and is made of Ag with a predetermined material.

## Description

### CROSS REFERENCES TO RELATED APPLICATIONS

The present invention contains subject matter related to Japanese Patent Application JP 2005-348293 filed in the Japanese Patent Office on December 1, 2005, the entire contents of which being incorporated herein by reference.

### BACKGROUND OF THE INVENTION

### 1. Field of the Invention

The present invention relates to a semiconductor light emitting device having a structure in which a light reflection layer reflects light emitted in a direction opposite to an emitting window toward the emitting window, and a method of manufacturing the semiconductor light emitting device.

### 2. Description of the Related Art

The external quantum efficiency of semiconductor light emitting devices such as light emitting diodes (LEDs) includes two factors, that is, internal quantum efficiency and light extraction efficiency, and a semiconductor light emitting device with a long life, low power consumption and high power can be achieved by improving these efficiencies. The former efficiency, that is, internal quantum efficiency is improved, for example, by controlling growth conditions correctly so as to obtain a good crystal with less crystal defects or less dislocation, or by having a layer structure capable of preventing the occurrence of a carrier overflow. On the other hand, the latter efficiency, that is, the light extraction efficiency is improved, for example, by having a geometric shape or a layer structure increasing the rate at which light emitted from an active layer enters an emitting window at angles inside an escape cone before the light is absorbed by a substrate or the active layer. Moreover, the light extraction efficiency can be improved by arranging a light reflection layer made of a material with high reflectivity so as to reflect light emitted in a direction opposite to the emitting window toward the emitting window.

In semiconductor light emitting devices such as light emitting diodes, the above-described light reflection layer typically has a role as an electrode injecting a current into a semiconductor layer; therefore, it is necessary for the light reflection layer to have a high electrical contact property with various semiconductor layers. Typically, as a material with a high electrical contact property with various semiconductor layers and high versatility, Al (aluminum), Au (gold), Pt (platinum), Ni (nickel), Pd (palladium) or the like is used. However, even if they are used for the light reflection layer, the reflectivity is not much increased, so in many cases, they are not suitable for applications which need high reflectivity.

It can be considered that Ag (silver) which has extremely high reflectivity is applied to the light reflection layer in such applications. Ag has a high electrical contact property with a long-wavelength range semiconductor layer such as an AlGaAs-based semiconductor or an AlGaInP-based semiconductor, so an ohmic contact is easily formed. However, Ag has a low electrical contact property with a short-wavelength range semiconductor layer such as a GaN-based semiconductor, so an ohmic contact close to a schottky contact is easily formed, compared to any other materials, so linearity declines. Thus, Ag has a low electrical contact property with a short-wavelength range semiconductor layer such as a GaN-based semiconductor. Therefore, in Japanese Unexamined Patent Application Publication No. 2004-260178, there have been proposed a technique of arranging an extremely thin layer of 0.1 nm to 0.5 nm thick including Pt, Pd or Ni between a light reflection layer made of Ag and a semiconductor layer, and a technique of heating a light reflection layer made of Ag at a low temperature (300°C) in consideration of the heat resistance of Ag.

### SUMMARY OF THE INVENTION

In the former technique of Japanese Unexamined Patent Application Publication No. 2004-260178, the electrical contact property can be improved. However, as a layer made of a material with low reflectivity is arranged between a light reflection layer and a semiconductor layer, the reflectivity declines inevitably, thereby high reflectivity is not expected. In the latter technique, as a light reflection layer made of Ag makes direct contact with a semiconductor layer, the reflectivity is high. However, even if the light reflection layer is simply heated at a low temperature, a schottky contact is hardly changed into an ohmic contact, so the electrical contact property is still low. As described above, in Japanese Unexamined Patent Application Publication No. 2004-260178, only either the reflectivity or the electrical contact property can be improved.

In view of the foregoing, it is desirable to provide a semiconductor light emitting device having high reflectivity and a high electrical contact property between a light reflection layer and a semiconductor layer, and a method of manufacturing the semiconductor light emitting device.

According to an embodiment of the invention, there is provided a semiconductor light emitting device including: a semiconductor layer; a base layer; and a light reflection layer. The semiconductor layer is formed by laminating a first conductive layer, an active layer and a second conductive layer in this order. The base layer is formed on a surface of the second conductive layer by adding Ag (silver) to a transition metal, and has a thickness of 1 nm to 10 nm inclusive. The light reflection layer is formed on a surface of the base layer by adding a predetermined material to Ag.

In the semiconductor light emitting device according to the embodiment of the invention, the base layer arranged between the light reflection layer and the semiconductor layer includes a transition metal with a large work function, so an energy barrier generated between the base layer and the semiconductor layer is extremely small. At this time, to prevent the interruption of conductivity by a surface level existing around the surface of the semiconductor layer, each of the materials of the semiconductor layer and the base layer is appropriately selected, thereby the light reflection layer makes ohmic contact with the semiconductor layer with the base layer in between, so the linearity is improved. Moreover, the base layer includes Ag as in the case of the light reflection layer, so the base layer can reflect light emitted from the semiconductor layer with high reflectivity. Therefore, when a current is injected into the semiconductor layer from the light reflection layer via the base layer, light is emitted in the semiconductor layer, and the emitted light is reflected by the light reflection layer and the base layer. Further, the thickness of the base layer is 1 nm to 10 nm inclusive, so there is less difficulty in thickness control in a manufacturing process, for example, when a thickness is controlled to be 0.1 nm to 0.5 nm. Thereby, the possibility of distributing the base layer on the semiconductor layer in an island form can be eliminated, so the light reflection layer reliably makes ohmic contact with the semiconductor layer with the base layer in between.

According to an embodiment of the invention, there is provided a method of manufacturing a semiconductor light emitting device including the steps of depositing a transition metal with a thickness of 1 nm to 10 nm inclusive on a semiconductor layer, and then depositing a material having metallic properties, the material formed by adding Ag and a predetermined material to the transition metal; and heating the transition metal and the material having metallic properties formed on the semiconductor layer at a predetermined temperature range in a predetermined time range to disperse Ag included in the material having metallic properties into a layer of the transition metal.

In the method of manufacturing a semiconductor light emitting device according to the embodiment of the invention, the layer of the transition metal is formed between the layer of the material having metallic properties and the semiconductor layer, so an energy barrier between the layer of the transition metal and the semiconductor layer is extremely small. At this time, to prevent the interruption of conductivity by a surface level existing around the surface of the semiconductor layer, each of the materials of the semiconductor layer and the layer of the transition metal is appropriately selected, thereby the layer of the material having metallic properties makes ohmic contact with the semiconductor layer with the layer of the transition metal in between, so the linearity is improved. Moreover, the layer of the transition metal includes Ag dispersed from the layer of the material having metallic properties, so the layer of the transition metal can reflect light emitted from the semiconductor layer with high reflectivity. Therefore, when a current is injected into the semiconductor layer from the layer of the material having metallic properties via the layer of the transition metal, light is emitted in the semiconductor layer, and the emitted light is reflected by the layer of the material having metallic properties and the layer of the transition metal. Further, the thickness of the layer of the transition metal is 1 nm to 10 nm inclusive, so there is less difficulty in thickness control in a manufacturing process, for example, when a thickness is controlled to be 0.1 nm to 0.5 nm. Thereby, the possibility of distributing the layer of the transition metal on the semiconductor layer in an island form can be eliminated, so the layer of the material having metallic properties reliably makes ohmic contact with the semiconductor layer with the layer of the transition metal in between.

In the semiconductor light emitting device according to the embodiment of the invention, the base layer including a transition metal with a large work function and Ag with extremely high reflectivity is arranged between the light reflection layer and the semiconductor layer, so the light reflection layer makes ohmic contact with the semiconductor layer with the base layer in between, and the base layer can reflect light emitted from the semiconductor layer with high reflectivity as in the case of the light reflection layer. Thereby, the semiconductor light emitting device with high reflectivity and a high electrical contact property between the light reflection layer and the semiconductor layer can be achieved.

In the method of manufacturing a semiconductor light emitting device according to the embodiment of the invention, the layer of the transition metal including a transition metal with a large work function and Ag with extremely high reflectivity is arranged between the layer of the material having metallic properties and the semiconductor layer, so the layer of the material having metallic properties makes ohmic contact with the semiconductor layer with the layer of the transition metal in between, and the layer of the transition metal can reflect light emitted from the semiconductor layer with high reflectivity as in the case of the layer of the material having metallic properties. Thereby, the semiconductor light emitting device with high reflectivity and a high electrical contact property between the layer of the material having metallic properties and the semiconductor layer can be achieved.

Other and further objects, features and advantages of the invention will appear more fully from the following description.

### BRIEF DESCRIPTION OF THE DRAWINGS

FIG. 1 is a sectional view of a light emitting diode according to an embodiment of the invention;
FIG. 2 is a simplified flowchart showing steps of manufacturing the light emitting diode;
FIG. 3 is a sectional view for describing a step of manufacturing the light emitting diode;
FIG. 4 is a conceptual diagram showing a state in which Ag included in a light reflection layer is dispersed into a part of a base layer;
FIG. 5 is a conceptual diagram showing a state in which Ag included in the light reflection layer is dispersed into the whole base layer;
FIG. 6 is a relationship diagram for describing a relationship between heating time and reflectivity;
FIG. 7 is a relationship diagram for describing current-voltage characteristics;
FIG. 8 is a sectional view for describing a step of manufacturing a light emitting diode according to a modification; and
FIG. 9 is a relationship diagram for describing a relationship between heating temperature and reflectivity in the light emitting diode of FIG. 8.

### DETAILED DESCRIPTION OF THE PREFERRED EMBODIMENTS

A preferred embodiment will be described in detail below referring to the accompanying drawings.

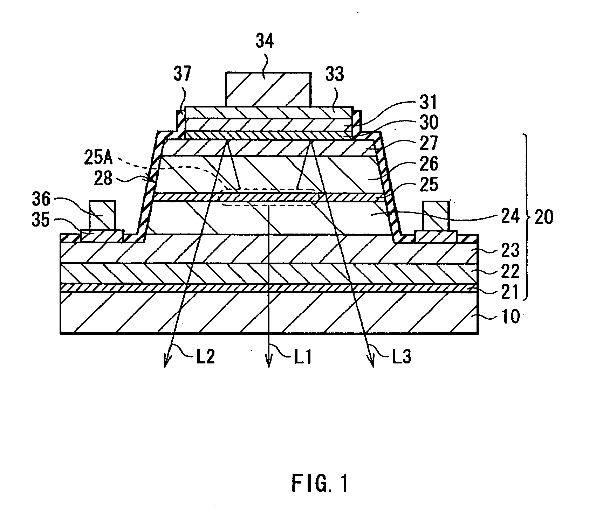

FIG. 1 shows a sectional view of a light emitting diode (LED) according to an embodiment of the invention. FIG. 1 is a schematic view, so dimensions and shapes in FIG. 1 are different from actual dimensions and shapes.

The light emitting diode is formed by growing a semiconductor layer 20 made of a nitride Group III-V compound semiconductor on a substrate 10. The semiconductor layer 20 is formed by laminating a buffer layer 21, a GaN layer 22, an n-type contact layer 23, an n-type cladding layer 24, an active layer 25, a p-type cladding layer 26 (a first p-type semiconductor layer) and a p-type contact layer 27 (a second p-type semiconductor layer) in order.

The nitride Group III-V compound semiconductor here is a gallium nitride-based compound including gallium (Ga) and nitrogen (N), and examples of the gallium nitride-based compound include GaN, AlGaN (aluminum gallium nitride), AlGaInN (aluminum gallium indium nitride) and the like. They may include n-type impurities of Group IV and VI elements such as Si (silicon), Ge (germanium), O (oxygen) and Se (selenium) or p-type impurities of Group II and IV elements such as Mg (magnesium), Zn (zinc) and C (carbon), if necessary.

The substrate 10 is made of a transparent substrate, for example, c-plane sapphire. The buffer layer 21 is made of, for example, undoped GaN with a thickness of 30 nm, and is formed on the c-plane sapphire by low-temperature growth. The GaN layer 22 is made of, for example, undoped GaN with a thickness of 0.5 µ m, and is formed on the c-plane sapphire with the buffer layer 21 in between through the use of a lateral direction crystal growth technique such as ELO (Epitaxial Lateral Overgrowth). The n-type contact layer 23 is made of, for example, n-type GaN with a thickness of 4.0 µ m, and the n-type cladding layer 24 is made of, for example, n-type AlGaN with a thickness of 1.0 µ m.

The active layer 25 has, for example, a multiquantum well structure in which three pairs of an undoped InₓGa₁₋ₓN well layer (0<x< 1) with a thickness of 3.5 nm and an undoped In_{y}Ga_{1-y}N barrier layer (0<y< 1) with a thickness of 7.0 nm are laminated. The active layer 25 has a light emitting region 25A where the recombination of electrons and holes produces photons in a central region of the active layer 25. The p-type cladding layer 26 is made of, for example, p-type AlGaN with a thickness of 0.5 µ m. The p-type contact layer 27 is made of, for example, p-type GaN with a thickness of 0.1 µm, and has a higher concentration of p-type impurities than the p-type cladding layer 26.

In a top portion of the n-type contact layer 23, the n-type cladding layer 24, the active layer 25, the p-type cladding layer 26 and the p-type contact layer 27, as will be described later, a portion from the p-type contact layer 27 to the top portion of the n-type contact layer 23 is selectively etched to form a convex mesa 28.

A base layer 30 and a light reflection layer 31 are laminated in this order on a part of a top surface of the mesa 28, that is, a top surface of the p-type contact layer 27.

The light reflection layer 31 is made of a material having metallic properties, for example, an Ag alloy with a thickness from 70 nm to 200 nm. The Ag alloy is formed by adding at least one selected from the group consisting of Pt (platinum), Pd (palladium), Au (gold), Cu (copper), In (indium) and Ga (gallium) to Ag, and the light reflection layer 31 may be made of so-called APC including, for example, 98% of Ag, 1% of Pd and 1% of Cu. Depending on the composition of the Ag alloy, in the case where the Ag alloy includes, for example, Pd, Cu, In and the like, even if the Ag alloy is heated at a high temperature exceeding 200°C, there is little possibility of a decline in optical characteristics (reflectivity) due to migration, aggregation or the like. Therefore, compared to pure Ag causing the above-described phenomenon at approximately 200°C, the Ag alloy has extremely large heat resistance. Moreover, the Ag alloy has lower reactivity to oxidation or sulfurization than pure Ag, so the Ag alloy is less subject to an influence from external environment. In this case, the Ag alloy is formed more preferably by sputtering than by evaporation, because adhesion can be extremely large by using sputtering, thereby peeling of the light reflection layer 31 can be prevented.

While the Ag alloy overcomes the above-described disadvantages of pure Ag, the Ag alloy has extremely large reflectivity like pure Ag. Thereby, the light reflection layer 31 has a function of reflecting light traveling in a direction opposite to the substrate 10 as an emitting window of light emitted from the light emitting region 25A of the active layer 25 toward the substrate 10. Moreover, the light reflection layer 31 is electrically connected to a p-side bump 34 which will be described later, so the light reflection layer 31 also has a function as a p-side electrode. Therefore, it is necessary for the light reflection layer 31 to have a high electrical contact property with the p-type contact layer 27. The light reflection layer 31 makes ohmic contact with the p-type contact layer 27 with the base layer 30 in between, so the light reflection layer 31 has a high electrical contact property.

The base layer 30 is made of, for example, a transition metal with Ag. The transition metal has a property that the transition metal easily reacts with N (nitrogen) in the p-type contact layer 27 to form an interstitial nitride, thereby an energy barrier between the base layer 30 and the p-type contact layer 27 can be extremely small, so the transition metal is considered as a material capable of improving an electrical contact property between the light reflection layer 31 and the p-type contact layer 27. However, to prevent the interruption of conductivity by a surface level existing around the surface of the p-type contact layer 27, it is important to appropriately select the materials of the p-type contact layer 27 and the base layer 30. In this case, as the transition metal included in the base layer 30, as a heat treatment (sintering) is carried out, a transition metal having a higher melting point than pure Ag, for example, at least one selected from Pd, Ni (nickel), Pt (platinum) and Rh (rhodium) is preferable, and in consideration of the above-described surface level, in the case where the p-type contact layer 27 is made of GaN, for example, Pd or Ni is preferable. Thus, by considering various conditions, the base layer 30 can make ohmic contact between the light reflection layer 31 and the p-type contact layer 27 so as to improve linearity.

Moreover, the base layer 30 is preferably formed by evaporation or sputtering with low input power. The use of such a method can prevent a change in the surface state of the p-type contact layer 27, so a decline in linearity due to a change from an ohmic contact to a schottky contact by a decline in the electrical contact property can be prevented.

As will be described later, Ag included in the base layer 30 is Ag dispersed from the light reflection layer 31 by a heat treatment (sintering), and the base layer 30 has reflectivity according to the concentration distribution of dispersed Ag. In other words, the reflectivity of the base layer 30, and by extension to the reflectivity of a mirror layer including the light reflection layer 31 and the base layer 30 can be changed by changing the concentration distribution of Ag included in the base layer 30.

More specifically, the more Ag included in the light reflection layer 31 is dispersed from an interface with the light reflection layer 31 to an interface with the p-type contact layer 27 in the base layer 30, the more the reflectivity of the mirror layer can be increased. When Ag is dispersed to reach the interface with the p-type contact layer 27, the reflectivity of the mirror layer can be largely increased, and when the concentration of Ag in the interface with the p-type contact layer 27 is equal to or higher than a predetermined concentration, the reflectivity of the mirror layer can be substantially as high (for example, approximately 95%) as the reflectivity of pure Ag (97%) throughout a wide wavelength range.

To disperse Ag into the base layer 30 as described above, it is important to precisely set the conditions of the heat treatment (sintering) (temperature, time) in consideration of the values of the thicknesses, thermal conductivities or the like of the base layer 30 and the light reflection layer 31. At this time, when the thickness of the base layer 30 is too thick, for example, 1 µ m, it takes an enormous time for the concentration of Ag in the interface with the p-type contact layer 27 in the base layer 30 to reach a predetermined value. On the other hand, when the thickness of the base layer 30 is too thin, for example, 0.1 nm to 0.5 nm, it is difficult to control the thickness when forming the base layer 30, and as a result, the base layer 30 may be distributed in an island form on the p-type contact layer 27. Therefore, to achieve a balance between a high throughput and a high electrical contact property, the thickness of the base layer 30 is preferably within a range from 1 nm to 10 nm inclusive. The way of setting the conditions (temperature, time) of the heat treatment (sintering) will be described later.

A p-side pad 33 is formed on a part of the top surface of the light reflection layer 31, and the p-side bump 34 is formed on a part of the top surface of the p-side pad 33. The p-side pad 33 has, for example, a structure in which Ti of 50 nm thick, Ni of 100 nm thick and Au of 300 nm thick are laminated in this order. The p-side bump 34 is made of, for example, Au of 5000 nm thick.

An n-side electrode 35 is formed on a part along the outer edge of the mesa 28 in the surface of the n-type contact layer 23, and an n-side bump 36 is formed on a part of the top surface of the n-side electrode 35. The n-side electrode 35 has, for example, a structure in which Ti of 50 nm thick, Ni of 100 nm thick and Au of 300 nm thick are laminated in this order. The n-side bump 36 is made of, for example, Au of 5000 nm thick. An insulating layer 37 is formed on the side surfaces of the mesa 28, the base layer 30 and the light reflection layer 31 and an exposed portion of the n-type contact layer 23. The insulating layer 37 is made of, for example, SiN of 300 nm thick.

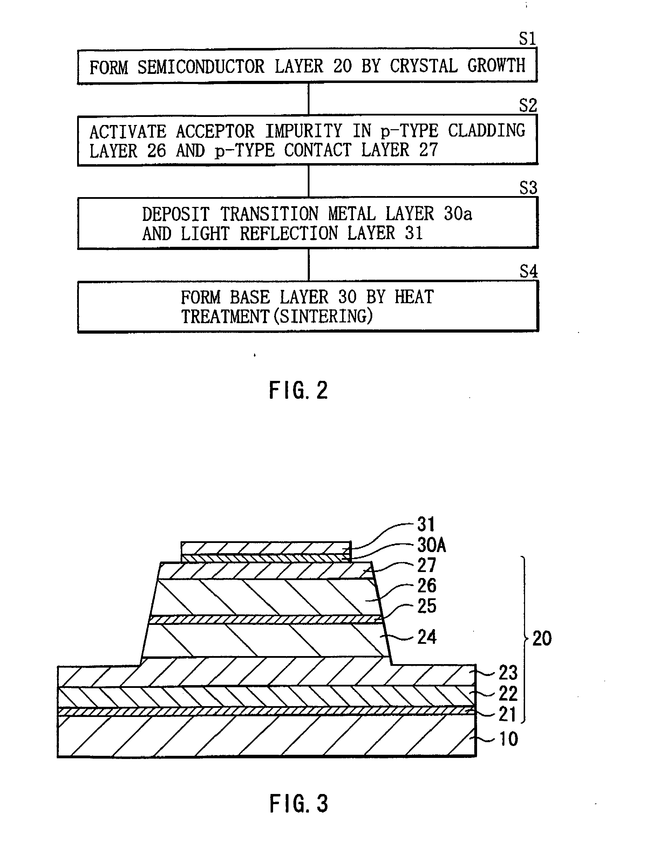

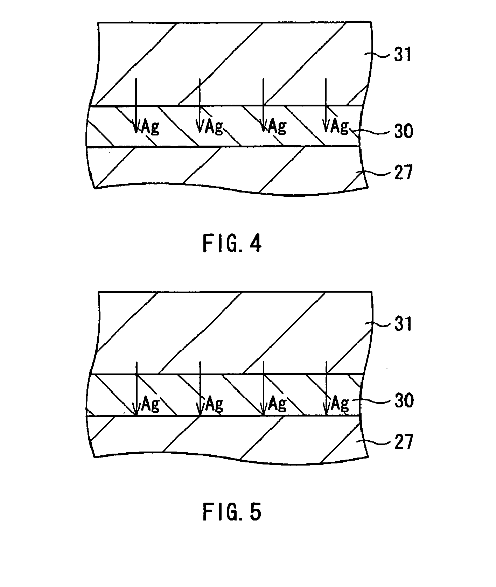

Next, an example of a method of manufacturing a light emitting diode with such a structure will be described in detail referring to FIGs. 2 through 5. FIG. 2 shows a simplified flowchart of steps of manufacturing the light emitting diode, and FIG. 3 shows a sectional structure of the light emitting diode in a manufacturing step. FIGs. 4 and 5 conceptually show a state where Ag included in the light reflection layer 31 is dispersed into the base layer 30.

To manufacture the light emitting diode, the semiconductor layer 20 made of a nitride Group III-V compound semiconductor is formed on the substrate 10 made of c-plane sapphire by, for example, MOCVD (Metal Organic Chemical Vapor Deposition). At this time, as the material of the GaN-based compound semiconductor, for example, trimethyl aluminum (TMA), trimethyl gallium (TMG), trimethyl indium (TMIn), or ammonia (NH₃) is used, and as the material of a donor impurity, for example, silane (SiH₄) is used, and as the material of an acceptor impurity, for example, bis(methylcyclopentadienyl)magnesium ((CH₃C₅H₄)₂Mg) or bis(cyclopentadienyl)magnesium ((C₅H₅)₂Mg) is used.

At first, the surface of the substrate 10 is cleaned by, for example, thermal cleaning. Next, the buffer layer 21A is grown on the cleaned substrate 10 by, for example, MOCVD at, for example, approximately 500°C, and then the GaN layer 22 is grown by, for example, a lateral direction crystal growth technique such as ELO at, for example, a growth temperature of 1000°C.

Next, the n-type contact layer 23, the n-type cladding layer 24, the active layer 25, the p-type cladding layer 26 and the p-type contact layer 27 are grown in order on the GaN layer 22 by, for example, MOCVD. In this case, the growth temperatures of the n-type contact layer 23, the n-type cladding layer 24, the p-type cladding layer 26 and the p-type contact layer 27 all of which do not include In are, for example, approximately 1000°C, and the growth temperature of the active layer 25 including In is, for example, 700°C to 800°C. After the semiconductor layer 20 is grown in such a manner by crystal growth (step S1), a heat treatment is carried out at, for example, 600° to 700°C for several tens of minutes to activate the acceptor impurity in the p-type cladding layer 26 and the p-type contact layer 27 (step S2).

Next, a resist pattern (not shown) with a predetermined shape corresponding to the shape of the mesa 28 is formed on the p-type contact layer 27, and etching is carried out through the use of the resist pattern as a mask until reaching the n-type contact layer 23 by, for example, RIE (Reactive Ion Etching) using a chlorine-based gas to form the mesa 28.

Then, as shown in FIG. 3, a transition metal layer 30A is deposited on the p-type contact layer 27 by, for example, evaporation or sputtering with low input power, and the light reflection layer 31 is formed on the deposited transition metal layer 30A by, for example, sputtering (step S3).

Next, a heat treatment (sintering) is subjected to the light reflection layer 31 and the transition metal layer 30A at a predetermined temperature range in a predetermined time range in a N₂ atmosphere to disperse Ag included in the light reflection layer 31 into the transition metal layer 30A, thereby the base layer 30 is formed (step S4, refer to FIGs. 4 and 5). After that, the p-side pad 33, the p-side bump 34, the n-side electrode 35 and the n-side bump 36 are formed in order. Thus, the light emitting diode according to the embodiment is manufactured.

Now, the heat treatment (sintering) as a characteristic part of the embodiment will be described in detail below.

As described above, a main purpose of the heat treatment (sintering) is to disperse Ag included in the light reflection layer 31 into the transition metal layer 30A to increase the reflectivity of a mirror layer including the light reflection layer 31 and the base layer 30. Therefore, the temperature range in the heat treatment is preferably a temperature or higher at which Ag included in the light reflection layer 31 can be sufficiently dispersed into the transition metal layer 30A, and a temperature lower than a temperature at which the light reflection layer 31 is rapidly degraded. The temperature range has time dependence, that is, the shorter the heat treatment time is, the higher the temperature range is shifted, and the longer the heat treatment time is, the lower the temperature range is shifted. On the other hand, as shown in FIG. 4, the time range in the heat treatment is preferably a time or longer in which Ag included in the light reflection layer 31 can be dispersed into a predetermined region including an interface with the light reflection layer 31 in the transition metal layer 30A on the basis of the set temperature and the thicknesses and thermal conductivities of the light reflection layer 31 and the transition metal layer 30A, and as shown in FIG. 5, the time range is more preferably a time or longer in which Ag included in the light reflection layer 31 can be dispersed into an interface with the p-type contact layer 27 in the transition metal layer 30A. In this case, in the case where the set temperature is high, the heat treatment time is shortened so that Ag can be dispersed into a predetermined region without degrading the light reflection layer 31, and as a result, high reflectivity can be achieved. In the case where the set temperature is low, the heat treatment time is extended so that Ag can be dispersed into the predetermined region, and as a result, high reflectivity can be achieved.

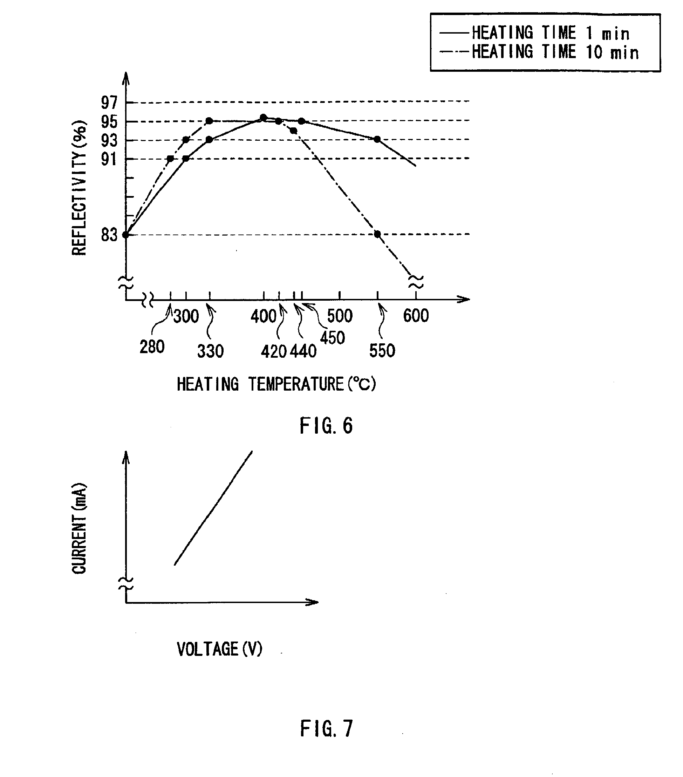

For example, in the case where the light reflection layer 31 is made of an Ag alloy with a thickness of 150 nm, and the transition metal layer 30A is made of Pd with a thickness of 5 nm, the reflectivity in the case where no heat treatment is carried out is only 83% as shown in FIG. 6, which is not higher than 90%. However, in the case where the heating time is fixed at 1 minute (a solid line in the drawing), when the set temperature is 300°C, the reflectivity is 91%, and when the set temperature is 400°C to 450°C, the reflectivity is 95%. Thus, when the set temperature is 400°C to 450°C, even if the temperature in manufacturing steps varies to some degree, stable reflectivity can be obtained. When the temperature is further increased, the reflectivity is slightly decreased until approximately 550°C, and when the temperature exceeds 550°C, the reflectivity is sharply decreased. It means that when the temperature exceeds 450°C, the degradation of the light reflection layer 31 starts, and when the temperature exceeds 550°C, the degradation of the light reflection layer 31 is severe. Therefore, when the heating time is 1 minute, the temperature range is preferably within a range from 300°C to 550°C inclusive, and more preferably within a range from 400°C to 450°C inclusive. Moreover, in the case where the heating time is as long as 10 minutes (a dashed line in the drawing), when the set temperature is 280°C, the reflectivity is 91%, and when the set temperature is 330°C to 420°C, the reflectivity is 95%. Thus, when the temperature is from 330°C to 420°C, even if the temperature varies to some extent in manufacturing steps, stable reflectivity can be obtained. When the temperature is further increased, the reflectivity is slightly decreased until approximately 430°C, and when the temperature exceeds 430°C, the reflectivity is sharply decreased. It means that when the temperature exceeds 430°C, the degradation of the light reflection layer 31 starts, and when the temperature exceeds 430°C, the degradation of the light reflection layer 31 is severe. Therefore, when the heating time is 10 minutes, the temperature range is preferably within a range from 280°C to 430°C inclusive, and more preferably within a range from 330°C to 420°C inclusive.

Thus, it is obvious that the shorter the heat treatment time is, the higher a preferable temperature range is shifted, and the longer the heat treatment time is, the lower the preferable temperature range is shifted. Moreover, in the case where the set temperature is high, when the heat treatment time is shortened, the degradation of the light reflection layer 31 can be minimized to achieve high reflectivity, and in the case where the set temperature is low, when the heat treatment time is extended, high reflectivity can be achieved.

In other words, in the light emitting diode, in spite of the fact that the base layer 30 is arranged between the light reflection layer 31 and the p-type contact layer 27, the light emitting diode can achieve as high reflectivity as pure Ag.

In the light emitting diode manufactured in such a manner, when a current is supplied to the p-side bump 34 and the n-side bump 36, the current is injected into the light emitting region 25A of the active layer 25, thereby light is emitted by the recombination of electrons and holes. Light L1 directly toward the substrate 10 as an emitting window in the light emitted from the light emitting region 25A passes through the substrate 10 to be emitted to outside, and lights L2 and L3 in a direction opposite to the substrate 10 as the emitting window are reflected to the substrate 10 by a mirror layer including the base layer 30 and the light reflection layer 31, and then pass through the substrate 10 to be emitted to outside.

At this time, the lights L2 and L3 are reflected by the mirror layer which includes the base layer 30 including Ag with extremely large reflectivity and the light reflection layer 31, so compared to the case where the lights L2 and L3 are reflected by a mirror layer not including Ag in a related art, the reflectivity and the light extraction efficiency are increased. In particular, in the case where the Ag content in the mirror layer is increased, the reflectivity and the light extraction efficiency of the light emitting diode are extremely large.

Moreover, as shown in FIG. 7, the current-voltage characteristics of the light emitting diode is substantially linear, so it is obvious that the light reflection layer 31 electrically connected to the p-side bump 34 makes ohmic contact with the p-type contact layer 27 with the base layer 30 including a transition metal with a large work function in between. Thereby, when the p-side bump 34 and the n-side bump 36 are driven, compared to the case where the p-side bump 34 makes contact with the p-type contact layer 27 with a layer not including a transition metal in between, the contact resistance can be reduced, thereby as a result, a drive voltage can be reduced.

Thus, in the embodiment, the base layer 30 including a transition metal with a large work function and Ag with extremely high reflectivity is arranged between the light reflection layer 31 and the p-type contact layer 27, so the light reflection layer 31 makes ohmic contact with the p-type contact layer 27 with the base layer 30 in between, and the base layer 30 can reflect light emitted from the semiconductor layer 20 with high reflectivity as in the case of the light reflection layer 31. Thereby, the light emitting diode having high reflectivity of the mirror layer including the base layer 30 and the light reflection layer 31 and a high electrical contact property between the light reflection layer 31 and the p-type contact layer 27 can be achieved.

Moreover, for example, even in the case where the light emitting diode subjected to the heat treatment (sintering) emits light for 200 hours in the atmosphere of high temperature and high humidity (70°C, 90%), the base layer 30 and the light reflection layer 31 are not degraded or peeled. Therefore, the adhesion of the light reflection layer 31 and the base layer 30 can be improved by the heat treatment (sintering). At this time, the variability rate of the reflectivity is approximately 1% which is within a measurement error tolerance range, so the variation of the reflectivity can be reduced by the heat treatment (sintering).

### [Modification]

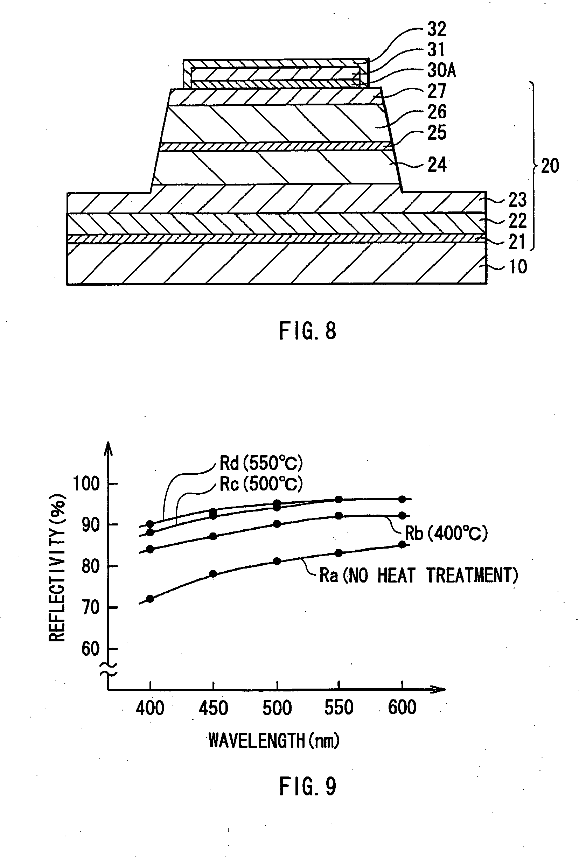

In the above embodiment, the base layer 30 and the light reflection layer 31 are exposed in a nitrogen atmosphere during the heat treatment (sintering). However, as shown in FIG. 8, after a protective layer 32 for protecting these layers from heat is formed, a heat treatment (sintering) may be carried out.

The protective layer 32 is made of a material capable of protecting the light reflection layer 31 from high temperatures by the above-described heat treatment, for example, at least one selected from the group consisting of Ni (nickel), Ti (titanium) and Pt, and the protective layer 32 has, for example, a thickness of 100 nm. Compared to the case where the protective layer 32 is not arranged, the upper limit of the temperature for the heat treatment, that is, the temperature at which the light reflection layer 31 is rapidly degraded is increased by approximately 200°C. Thus, when the protective layer 32 is arranged, in the heat treatment, for example, in the case where the heating time is 10 minutes, even if the set temperature is approximately 500°C, while minimizing the degradation of the light reflection layer 31, high reflectivity can be achieved.

For example, in the case where the protective layer 32 is made of Ni with a thickness of 100 nm, the light reflection layer 31 is made of an Ag alloy with a thickness of 360 nm, and the transition metal layer 30A is made of Pd with a thickness of 2 nm, the reflectivity in the case where no heat treatment is carried out does not exceed 90% as shown by Ra in FIG. 9. However, the reflectivity in the case where the set temperature is 400°C and the heating time is 10 minutes exceeds 91% in a part of a wavelength range as shown by Rb in FIG. 9; the reflectivity in the case where the heating temperature is 500°C exceeds 93% in most of the wavelength range as shown by Rc in FIG. 9; and the reflectivity in the case where the heating temperature is 550°C is 95% in nearly the whole wavelength range as shown by Rd in FIG. 9.

The reflectivity is increased according to an increase in the heating temperature in a state where the heating time is fixed in such a manner, because the speed of dispersing Ag included in the light reflection layer 31 toward an interface with the p-type contact layer 27 in the transition metal layer 30A becomes faster. Thereby, when the heat treatment is carried out at a higher temperature than the set temperature in the embodiment after covering the light reflection layer 31 and the base layer 30 with the protective layer 32, high reflectivity can be achieved in a shorter time while preventing the degradation of the light reflection layer 31.

Although the invention is described referring to the embodiment and the modification, the invention is not limited to the embodiment and the modification, and can be variously modified.

For example, in the above embodiment, the light emitting diode including a nitride Group III-V compound semiconductor is described; however, the invention is not limited to this, and the invention is applicable to a long-wavelength range light emitting diode including any other semiconductor material, for example, an AlGaAs-based or AlGaInP-based semiconductor.

It should be understood by those skilled in the art that various modifications, combinations, sub-combinations and alterations may occur depending on design requirements and other factors insofar as they are within the scope of the appended claims or the equivalents thereof.

## Claims

1. A semiconductor light emitting device comprising:
a semiconductor layer formed by laminating a first conductive layer, an active layer and a second conductive layer in this order;
a light reflection layer formed by adding a predetermined material to Ag (silver); and
a base layer formed between the semiconductor layer and the light reflection layer, the base layer made of a transition metal with Ag with a thickness of 1 nm to 10 nm inclusive.

2. The semiconductor light emitting device according to claim 1, wherein
Ag in the base layer is added to a predetermined region including an interface with the light reflection layer.

3. The semiconductor light emitting device according to claim 1, wherein
Ag in the base layer is added to the whole base layer.

4. The semiconductor light emitting device according to anyone of claims 1 to 3, wherein
the predetermined material includes at least one selected from the group consisting of Pt (platinum), Pd (palladium), Au (gold), Cu (copper), In (indium) and Ga (gallium).

5. The semiconductor light emitting device according to anyone of claims 1 to 4, wherein
the transition metal has a higher melting point than Ag.

6. The semiconductor light emitting device according to claim 5, wherein
the transition metal includes at least one selected from the group consisting of Pd, Ni (nickel), Pt (platinum) and Rh (rhodium).

7. The semiconductor light emitting device according to anyone of claims 1 to 6, wherein
the light reflection layer is formed by sputtering.

8. The semiconductor light emitting device according to anyone of claims 1 to 7, wherein
the second conductive layer is formed by laminating a first p-type semiconductor layer and a second p-type semiconductor layer in this order, the first p-type semiconductor layer and the second p-type semiconductor layer made of a Group III-V nitride semiconductor, and
the second p-type semiconductor layer has a higher p-type impurity concentration than the first p-type semiconductor layer.

9. A method of manufacturing a semiconductor light emitting device comprising the steps of:
depositing a transition metal with a thickness of 1 nm to 10 nm inclusive on a semiconductor layer, and then depositing a material having metallic properties, the material formed by adding Ag and a predetermined material to the transition metal; and
heating the transition metal and the material having metallic properties formed on the semiconductor layer at a predetermined temperature range in a predetermined time range to disperse Ag included in the material having metallic properties into a layer of the transition metal.

10. The method of manufacturing a semiconductor light emitting device according to claim 9, wherein
the predetermined temperature range is a temperature or higher at which Ag included in the material having metallic properties can be dispersed into the layer of the transition metal, and a temperature lower than the melting point of the material having metallic properties, and
the predetermined time range is a time or longer in which Ag included in the material having metallic properties can be dispersed into a predetermined region including an interface with a layer of the material having metallic properties in a layer of the transition metal on the basis of a set temperature, the thicknesses of the material having metallic properties and the transition metal, the thermal conductivities of the material having metallic properties and the transition metal.

11. The method of manufacturing a semiconductor light emitting device according to claim 10, wherein
the predetermined time range is a time or longer in which Ag included in the material having metallic properties can be dispersed into an interface with the semiconductor layer in the layer of the transition metal.

12. The method of manufacturing a semiconductor light emitting device according to anyone of claims 9 to 11, wherein
the predetermined material includes at least one selected from the group consisting of Pt (platinum), Pd (palladium), Au (gold), Cu (copper), In (indium) and Ga (gallium).

13. The method of manufacturing a semiconductor light emitting device according to anyone of claims 9 to 12, wherein
the transition metal has a higher melting point than Ag.

14. The method of manufacturing a semiconductor light emitting device according to anyone of claims 9 to 13, wherein
the transition metal includes at least one selected from the group consisting of Pd, Ni (nickel), Pt (platinum) and Rh (rhodium).
